# EUROPEAN PATENT SPECIFICATION

(11) **EP 3 588 590 B1**
(45) Date of publication and mention of the grant of the patent: **13.05.2020**
(21) Application number: 18382462.2
(22) Date of filing: 22.06.2018
(51) Int. Cl.: H01L 35/04, H01L 35/32

(54) **THERMOELECTRIC MODULE**
THERMOELEKTRISCHES MODUL
MODULE THERMOÉLECTRIQUE

(43) Date of publication of application: 01.01.2020
(73) Proprietor: CS Centro Stirling, S.Coop., 20550 Aretxabaleta (ES)
(72) Inventor: GARCIA RAMOS, Gustavo, 01010 VITORIA-GASTEIZ (ES); MARTINEZ FILGUEIRA, Pablo, 01008 VITORIA-GASTEIZ (ES); ARANCETA AGUIRRE, Francisco Javier, 48220 ABADIÑO (ES); ESKUBI UGARTE, Mauricio, 01479 IZORIA (ES)
(74) Representative: Igartua, Ismael

(56) References cited:
- WO-A1-2011/014479
- JP-A- H 104 217
- JP-A- 2000 349 351
- JP-A- 2006 294 935
- US-A1- 2010 059 096
- US-A1- 2013 228 204
- US-A1- 2013 255 742

## Description

### TECHNICAL FIELD

The present invention relates to thermoelectric modules which use thermoelectric effect to convert thermal energy into electrical energy and/or vice versa.

### PRIOR ART

Thermoelectric modules are widely known. They generally comprise a plurality of elements electrically connected to one another for generating an electrical path. A potential difference is generated between the first and the last thermoelectric elements (in reference to the electrical path) either when a current is inducted therethrough (for heating or cooling a surface or element by means of the Peltier effect) or when a temperature gradient is generated between the two reference faces of the thermoelectric module (for generating electricity, Seebeck effect). Thermoelectric elements have different properties (N-type and P-type) and are attached to one another in an intercalated manner.

Another type of thermoelectric module, in which only one type of thermoelectric elements (N-type or P-type) is used, is known in recent times. These configurations are commonly known as "unileg" configurations.

EP3054493A1 discloses a "unileg"-type thermoelectric module. The thermoelectric module comprises a plurality of first connectors, a plurality of conversion (or thermoelectric) elements, each of them connected at one end to one of the first electrodes, and a plurality of second electrodes, each of them connected to another end of the conversion elements. A first electrode and a second electrode are connected by means of a connector, forming a Z-shaped element between them.

US2010059096A1 discloses a thermoelectric module comprising at least one thermoelectric element with thermoelectric properties, the thermoelectric element comprising a first reference face, a second reference arranged opposite one another, and at least one dividing groove dividing said thermoelectric element into two reference segments joined together by means of an intermediate segment and extending from one of said reference faces to the other reference face, both reference segments comprising part of the first reference face and part of the second reference face of the thermoelectric element.

### DISCLOSURE OF THE INVENTION

The object of the invention is to provide a thermoelectric module, as defined in the claims.

The thermoelectric module comprises at least one element with thermoelectric properties (a thermoelectric element) comprising a first reference face and a second reference face arranged opposite one another. The thermoelectric element further comprises at least one dividing groove dividing said thermoelectric element into two reference segments joined together by means of an intermediate segment, both reference segments comprising part of the first reference face and part of the second reference face of the thermoelectric element. All the segments of one and the same thermoelectric element are electrically connected in series, and at least one of the reference segments comprises a neutral short-circuited area, . If both reference segments comprise a neutral area, the neutral area of one of the reference segments would span a greater length between the corresponding parts of the opposite reference faces than the neutral area of the other reference segment.

The neutral area thereby causes the possible voltage drop between the corresponding parts of the two opposite reference faces not to be the same in both reference segments, which allows having a voltage difference between both reference segments, despite them being arranged in one and the same thermoelectric element. As a result, a voltage difference can be generated on one and the same reference face of one and the same thermoelectric element, an aspect that is not possible in the prior art.

Therefore, the proposed module has the major advantage of allowing the use of the same reference face for the connections of a thermoelectric element with the outside of the module (or with other thermoelectric elements), without requiring connectors with complex shapes like in the prior art, which makes it significantly easier to assemble a thermoelectric module, and furthermore considerably reduces its costs. Furthermore, since the connections can be made on one and the same reference face, the thermoelectric element can be used in environments with higher temperatures compared to the prior art, given that problems caused by expansions in the event of high temperatures are prevented.

These and other advantages and features of the invention will become evident in view of the drawings and detailed description of the invention.

### DESCRIPTION OF THE DRAWINGS

Figure 1 shows an embodiment of a thermoelectric module according to the invention.
Figure 2 shows a thermoelectric element of another embodiment of a thermoelectric module according to the invention, with a dividing groove.
Figure 3 shows a thermoelectric element of another embodiment of a thermoelectric module according to the invention, with a plurality of dividing grooves.
Figure 4 shows another embodiment of a thermoelectric module according to the invention, comprising a plurality of thermoelectric elements.
Figure 5 shows another embodiment of a thermoelectric module according to the invention, comprising a plurality of thermoelectric elements.
Figure 6a is a perspective view of another embodiment of a thermoelectric module according to the invention, comprising a thermoelectric element with a plurality of dividing grooves.
Figure 6b is another perspective view of the thermoelectric module of Figure 6a.

### DETAILED DISCLOSURE OF THE INVENTION

The invention relates to a thermoelectric module 100 comprising at least one element with thermoelectric properties (a thermoelectric element 1). The thermoelectric element 1 comprises a first reference face 1.1 and a second reference face 1.2 arranged opposite one another. As a result of its thermoelectric properties, the thermoelectric element is suitable for converting thermal energy into electrical energy and/or vice versa, as described in detail below. If the two reference faces 1.1 and 1.2 are subjected to different temperatures, an electrical voltage difference is generated between said reference faces 1.1 and 1.2. If, in contrast, an electric current is applied through the thermoelectric element 1, a temperature gradient is generated between the two reference faces 1.1 and 1.2.

The module 100 comprises in some embodiments a thermoelectric element 1, and comprises in other embodiments a plurality of thermoelectric elements 1 connected to one another, as explained below.

The thermoelectric element 1 (or the thermoelectric elements 1) comprises in some embodiments a prism shape (preferably with a rectangular base), and in other embodiments a shape with an annular section (a disk, a ring, or a cylinder, for example). All the thermoelectric elements 1 of one and the same module 100 preferably comprise the same shape.

In any of the embodiments of the module 100, each thermoelectric element 1 comprises at least one dividing groove 3 (in the case of a thermoelectric element 1 with a prism shape), or at least one dividing groove 3.1 or 3.2 (in the case of a thermoelectric element 1 with shape with an annular section), dividing said thermoelectric element 1 into two reference segments Sref joined together by means of an intermediate segment 1.0 and extending from one of said reference faces 1.1 and 1.2 to another one of said reference faces 1.1 and 1.2, both reference segments Sref comprising part of the first reference face 1.1 and part of the second reference face 1.2 of the thermoelectric element 1.

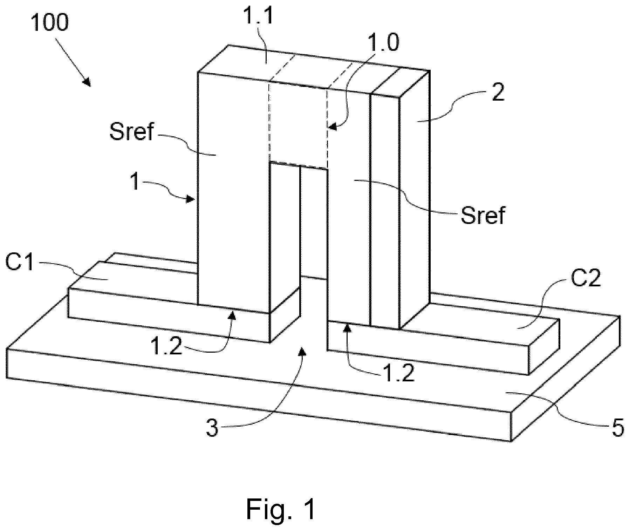

In the simplest configuration of a thermoelectric module 100, the module 100 comprises a single thermoelectric element as depicted by way of example in Figure 1 (the thermoelectric element 1 is a prism with a rectangular base). As can be seen, one of the reference faces 1.1 is divided by the dividing groove 3, whereas the other reference face 1.2 is formed by the reference segments Sref and the intermediate segment 1.0 (depicted with broken lines).

All the reference segments Sref of one and the same thermoelectric element 1 are electrically connected in series, and at least one of the two reference segments Sref comprises a neutral short-circuited area. This thereby causes the possible voltage drop between the two reference faces 1.1 and 1.2 to be lower in the reference segment Sref comprising the neutral area than in the other reference segment Sref. The larger the part of the reference segment Sref spanning the neutral area between the two reference faces 1.1 and 1.2 is, the greater the difference between the possible voltage drops of both reference segments Sref will be, so the neutral area preferably spans from the first reference face 1.1 to the second reference face 1.2 (as shown in Figure 1).

Preferably, only one of the reference segments Sref comprises a neutral area, but if the two reference segments Sref have at least one neutral area, the neutral area (or the sum of neutral areas) of one of the reference segments Sref would have a greater length between the reference faces 1.1 and 1.2 than the neutral area (or sum of neutral areas) of the other reference segment Sref, such that a different electrical voltage drop in the two reference segments Sref (between the corresponding parts of the reference faces 1.1 and 1.2) is enabled.

Therefore, with the proposed thermoelectric element 1, a voltage difference can be obtained between the two parts of one and the same reference face 1.1 or 1.2 separated by the dividing groove 3, each of said parts belonging to a reference segment Sref, making the assembly of the thermoelectric modules 100 comprising at least one of said thermoelectric elements 1 easier. Without the neutral areas, even with dividing grooves, the electrical voltage drop in a reference segment Sref would be canceled out by the electrical voltage drop of the other reference segment Sref.

To generate a neutral area, the corresponding area of the thermoelectric element 1 can be metallized, or a conductive element 2 is preferably attached to said area, short-circuiting it. The conductive element 2 can be a silver metal coating, for example, or another type of coating or material different from that of the thermoelectric element 1 and having properties that result in the aforementioned effect. In summary, the conductive element 2 must have a greater electrical conductivity than the thermoelectric element 1.

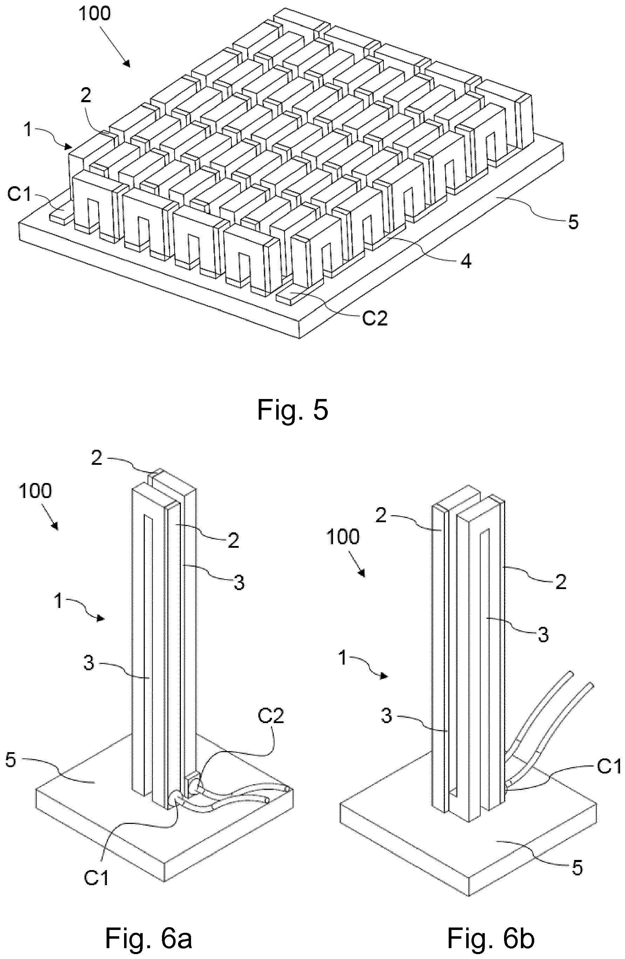

In some embodiments, the thermoelectric element 1 comprises a plurality of dividing grooves 3 (as shown in Figures 6a and 6b) or 3.1 and 3.2, each dividing groove 3 or 3.1 and 3.2 dividing the thermoelectric element 1 into two reference segments Sref communicated by a corresponding intermediate segment 1.0. All the segments Sref and 1.0 are electrically connected in series. At least one of the two reference segments Sref divided by each of the dividing grooves 3 or 3.1 and 3.2 comprises a neutral area (and if the two reference segments Sref have at least one neutral area, one of them spans a smaller length between the corresponding parts of the reference faces 1.1 and 1.2, as described above), and the neutral areas are distributed in such a way in the thermoelectric element 1 that only one of the reference segments Sref joined together by one and the same intermediate segment 1.0 comprises one of said neutral areas (or one of said reference segments Sref always has a neutral area having a smaller length between the corresponding parts of the reference faces 1.1 and 1.2 than the other reference segment Sref).

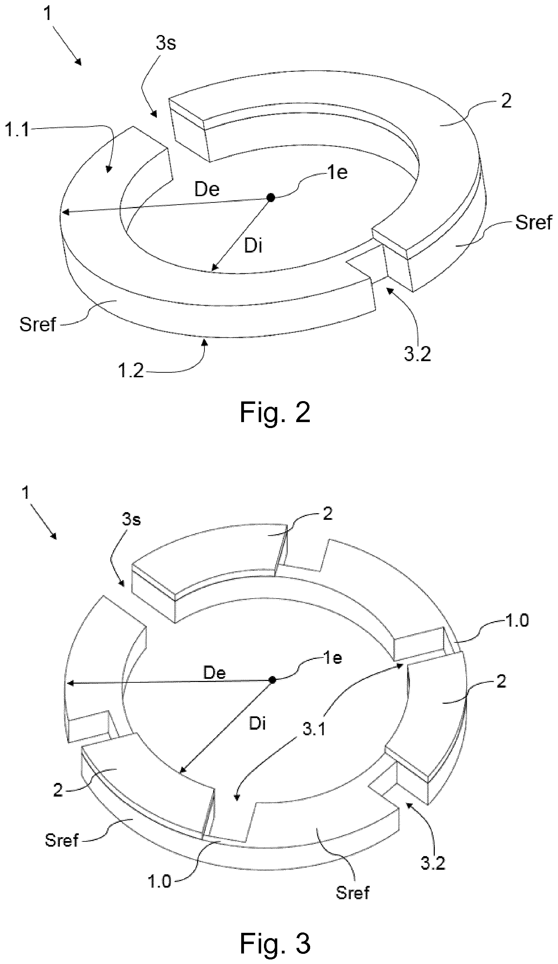

When a thermoelectric element 1 comprises a shape with an annular section (like the one depicted in Figure 2, for example), said thermoelectric element 1 comprises a specific inner diameter Di and a specific outer diameter De greater than the inner diameter Di. The thermoelectric element 1 comprises an opening 3s in addition to the dividing groove 3.1 or 3.2 (or dividing grooves 3.1 and 3.2), extending from the inner diameter Di to the outer diameter De, i.e., said opening 3s extends radially through the entire thermoelectric element 1, such that two areas of said thermoelectric element 1 are physically separated from one another by said opening 3s.

In the embodiments in which the thermoelectric element 1 comprises a shape with an annular section and comprises a plurality of dividing grooves 3.1 and 3.2, said dividing grooves 3.1 and 3.2 are of a first type of dividing groove 3.1, extending from the inner diameter Di towards the outer diameter De without reaching same, and of a second type of dividing groove 3.2, extending from the outer diameter De towards the inner diameter Di without reaching same. Both types of dividing grooves 3.1 and 3.2 are distributed in an alternating manner along the thermoelectric element 1, around a central axis 1e of said thermoelectric element 1, as shown by way of example in Figure 3.

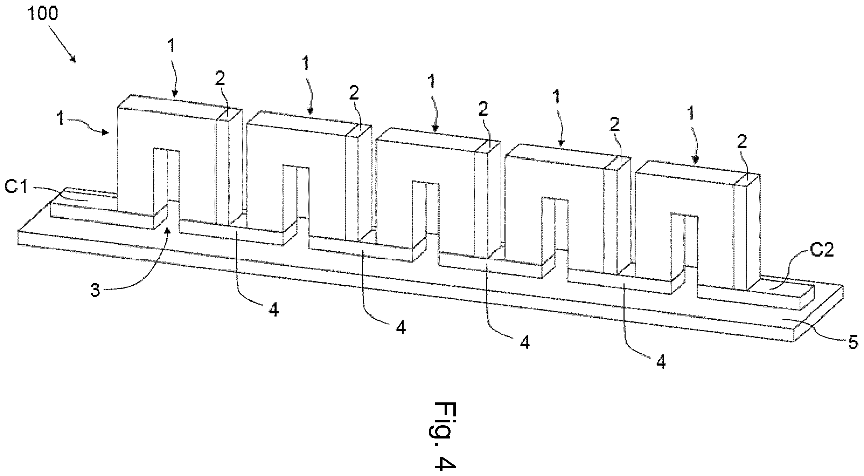

The module 100 comprises, in any of its embodiments, a first connector C1 and a second connector C2 for connection thereof to the outside, each of said connectors C1 and C2 being attached to a respective reference segment Sref, preferably by means of welding, said two reference segments Sref being the reference segments Sref of the thermoelectric element 1 arranged farthest away from one another in the serial electrical connection. In this manner, when the module 100 comprises a single thermoelectric element 1 (example of Figure 1), both connectors C1 and C2 are attached to said thermoelectric element 1, to the same reference face 1.1 or 1.2 of said thermoelectric element 1, whereas if it comprises a plurality of thermoelectric elements 1 (see Figures 4 and 5), each connector C1 and C2 is connected to a respective thermoelectric element 1. In this latter case, every two thermoelectric elements 1 are connected to one another by means of a corresponding attachment element 4 which is attached to a respective reference segment Sref of each of said thermoelectric elements 1, preferably by means of welding. The attachment elements 4 connect two adjacent reference segments Sref through the same face, where simple attachment elements 4 which can furthermore be readily attached to the corresponding reference segments Sref in one and the same process can be used.

The module 100 can further comprise a base 5 or substrate where the connectors C1 and C2, the attachment elements 4 (if present), and the thermoelectric elements 1 (or the thermoelectric element 1) are supported. The connectors C1 and C2, and the attachment elements 4, if present, are attached to said base 5, preferably by means of welding, the thermoelectric elements 1 being preferably supported on (and attached to) the connectors C1 and C2 and the attachment elements 4 (if present). In the embodiments with attachment elements 4, these elements can be attached to the base 5 and to the corresponding reference segments Sref in one and the same operation, and the connectors C1 and C2 can also be attached to the base 5 and to the reference segments Sref in said operation, which makes the process of assembling the corresponding module 100 simpler, faster, and easier.

## Claims

1. Thermoelectric module comprising at least one thermoelectric element (1) with thermoelectric properties, the thermoelectric element (1) comprising a first reference face (1.1) and a second reference face (1.2) arranged opposite one another, and at least one dividing groove (3; 3.1, 3.2) dividing said thermoelectric element (1) into two reference segments (Sref) joined together by means of an intermediate segment (1.0) and extending from one of said reference faces (1.1, 1.2) to the other reference face (1.1, 1.2), both reference segments (Sref) comprising part of the first reference face (1.1) and part of the second reference face (1.2) of the thermoelectric element (1), all the segments (Sref, 1.0) being electrically connected in series, **characterized in that** at least one of the reference segments (Sref) comprises a neutral short-circuited area of a given length between the corresponding parts of the two reference faces (1.1, 1.2), such that said neutral area thereby causes the possible voltage drop between the corresponding parts of the two opposite reference faces (1.1, 1.2) not to be the same in both reference segments (Sref), which allows having a voltage difference between both reference segments (Sref).

2. Thermoelectric module according to claim 1, wherein the reference segment (Sref) comprises an area extending to generate an area of a given length between the corresponding parts of the two reference faces (1.1, 1.2) that is metallized or in contact with a conductive element (2), said area being a neutral area.

3. Thermoelectric module according to claim 2, wherein the conductive element (2) is a metal coating, preferably a silver coating, comprising an electrical conductivity greater than the electrical conductivity of the thermoelectric element (1).

4. Thermoelectric module according to any of claims 1 to 3, wherein the thermoelectric element (1) comprises a plurality of dividing grooves (3; 3.1, 3.2), each dividing groove (3; 3.1, 3.2) dividing the thermoelectric element (1) into two reference segments (Sref) communicated by a corresponding intermediate segment (1.0) and all the reference segments (Sref) being electrically connected in series to one another through the corresponding intermediate segments (1.0), one of the two reference segments (Sref) divided by each of the dividing grooves (3; 3.1, 3.2) comprising a neutral area, and the neutral areas being distributed in such a way in the thermoelectric element (1) that only one of the reference segments (Sref) joined together by an intermediate segment (1.0) comprises one of said neutral areas.

5. Thermoelectric module according to any of claims 1 to 3, wherein the two reference segments (Sref) separated by a dividing groove (3; 3.1, 3.2) comprise at least one neutral area, the neutral area of one of the reference segments (Sref) comprising a greater length between the corresponding parts of the opposite reference faces (1.1, 1.2) than the length between the corresponding parts of said reference faces (1.1, 1.2) of the other reference segment (Sref).

6. Thermoelectric module according to claim 5, wherein the thermoelectric element (1) comprises a plurality of dividing grooves (3; 3.1, 3.2), each dividing groove (3; 3.1, 3.2) dividing the thermoelectric element (1) into two reference segments (Sref) communicated by a corresponding intermediate segment (1.0) and all the reference segments (Sref) being electrically connected in series to one another through the corresponding intermediate segments (1.0), the length of the neutral area of one of the two reference segments (Sref) joined together by an intermediate segment (1.0) being greater than the length of the neutral area of the other reference segment (Sref).

7. Thermoelectric module according to any of claims 1 to 6, wherein the thermoelectric element (1) comprises a prism shape, preferably with a rectangular base.

8. Thermoelectric module according to any of claims 1 to 6, wherein the thermoelectric element (1) comprises a shape with an annular section with a specific inner diameter (Di) and a specific outer diameter (De) greater than the inner diameter (Di), and comprises an opening (3s) extending from the inner diameter (Di) to the outer diameter (De).

9. Thermoelectric module according to claim 8, wherein the thermoelectric element (1) comprises a plurality of dividing grooves (3.1, 3.2) which are divided into a first type of dividing groove (3.1), extending from the inner diameter (Di) towards the outer diameter (De) without reaching same, and a second type of dividing groove (3.2), extending from the outer diameter (De) towards the inner diameter (Di) without reaching same, both types of dividing grooves (3.1, 3.2) being distributed in an alternating manner along the thermoelectric element (1), around a central axis (1e) of said thermoelectric element (1).

10. Thermoelectric module according to claim 8 or 9, wherein the thermoelectric element (1) is a disk, a ring, or a cylinder.

11. Thermoelectric module according to any of claims 1 to 10, comprising a first connector (C1) and a second connector (C2) for connection thereof to the outside, each of said connectors (C1, C2) being attached to a respective reference segment (Sref), preferably by means of welding, said two reference segments (Sref) being the reference segments (Sref) of the thermoelectric element (1) arranged farthest away from one another in the serial electrical connection.

12. Thermoelectric module according to claim 11, comprising a base (5), the first connector (C1) and the second connector (C2) being attached to said base (5), preferably by means of welding.

13. Thermoelectric module according to any of claims 1 to 10, comprising a plurality of thermoelectric elements (1), every two thermoelectric elements (1) being connected to one another by means of a corresponding attachment element (4) which is attached to a respective reference segment (Sref) of each of said thermoelectric elements (1), preferably by means of welding.

14. Thermoelectric module according to claim 13, comprising a base (5), the attachment elements (4) being attached to said base (5), preferably by means of welding.

15. Thermoelectric module according to claim 13 or 14, comprising a first connector (C1) and a second connector (C2) for connection thereof to the outside, each of said connectors (C1, C2) being attached to a reference segment (Sref) of a respective thermoelectric element (1), preferably by means of welding, said two reference segments (Sref) being the reference segments (Sref) arranged farthest away from one another in the serial electrical connection.

## Patentansprüche

1. Thermoelektrisches Modul umfassend mindestens ein thermoelektrisches Element (1) mit thermoelektrischen Eigenschaften, wobei das thermoelektrische Element (1) eine erste Referenzfläche (1.1) und eine zweite Referenzfläche (1.2), die einander gegenüberliegend angeordnet sind, und mindestens eine Trennnut (3; 3.1, 3.2), die das genannte thermoelektrische Element (1) in zwei Referenzsegmente (Sref) teilt, die durch ein Zwischensegment (1.0) miteinander verbunden sind und sich von einer der genannten Referenzflächen (1.1, 1.2) zur anderen Referenzfläche (1.1, 1.2) erstrecken, wobei beide Referenzsegmente (Sref) einen Teil der ersten Referenzfläche (1.1) und einen Teil der zweiten Referenzfläche (1.2) des thermoelektrischen Elements (1) umfassen, wobei alle Segmente (Sref, 1.0) elektrisch in Reihe geschaltet sind, **dadurch gekennzeichnet, dass** mindestens eines der Referenzsegmente (Sref) einen neutralen kurzgeschlossenen Bereich mit einer gegebenen Länge zwischen den entsprechenden Teilen der beiden Referenzflächen (1.1, 1.2) aufweist, so dass der genannte neutrale Bereich dabei bewirkt, dass der mögliche Spannungsabfall zwischen den entsprechenden Teilen der beiden gegenüberliegenden Referenzflächen (1.1, 1.2) in den beiden Referenzsegmenten (Sref) nicht gleich ist, was eine Spannungsdifferenz zwischen den beiden Referenzsegmenten (Sref) ermöglicht.

2. Thermoelektrisches Modul nach Anspruch 1, wobei das Referenzsegment (Sref) einen sich derart erstreckenden Bereich umfasst, dass zwischen den entsprechenden Teilen der beiden Referenzflächen (1.1, 1.2) ein metallisierter oder mit einem leitenden Element (2) in Kontakt stehender Bereich mit einer gegebenen Länge entsteht, wobei der genannte Bereich ein neutraler Bereich ist.

3. Thermoelektrisches Modul nach Anspruch 2, wobei das leitende Element (2) eine Metallbeschichtung, vorzugsweise eine Silberbeschichtung, ist, deren elektrische Leitfähigkeit größer als die elektrische Leitfähigkeit des thermoelektrischen Elements (1) ist.

4. Thermoelektrisches Modul nach einem der Ansprüche 1 bis 3, wobei das thermoelektrische Element (1) eine Vielzahl von Trennnuten (3; 3.1, 3.2) aufweist, wobei jede Trennnut (3; 3.1, 3.2) das thermoelektrische Element (1) in zwei, durch ein entsprechendes Zwischensegment (1.0) verbundene Referenzsegmente (Sref) teilt und alle Referenzsegmente (Sref) durch die entsprechenden Zwischensegmente (1.0) elektrisch in Reihe geschaltet sind, wobei eines der beiden durch die jeweiligen Teilungsnuten (3; 3.1, 3.2) geteilten Referenzsegmente (Sref) einen neutralen Bereich aufweist und die neutralen Bereiche in dem thermoelektrischen Element (1) so verteilt sind, dass nur eines der durch ein Zwischensegment (1.0) miteinander verbundenen Referenzsegmente (Sref) einen der genannten neutralen Bereiche aufweist.

5. Thermoelektrisches Modul nach einem der Ansprüche 1 bis 3, wobei die beiden durch eine Trennnut (3; 3.1, 3.2) getrennten Referenzsegmente (Sref) mindestens einen neutralen Bereich aufweisen, wobei die Länge des neutralen Bereichs eines der Referenzsegmente (Sref) zwischen den entsprechenden Teilen der gegenüberliegenden Referenzflächen (1.1, 1.2) größer ist als die Länge zwischen den entsprechenden Teilen der genannten Referenzflächen (1.1, 1.2) des anderen Referenzsegments (Sref).

6. Thermoelektrisches Modul nach Anspruch 5, wobei das thermoelektrische Element (1) eine Vielzahl von Trennnuten (3; 3.1, 3.2) aufweist, wobei jede Trennnut (3; 3.1, 3.2) das thermoelektrische Element (1) in zwei durch ein entsprechendes Zwischensegment (1.0) verbundene Referenzsegmente (Sref) teilt und alle Referenzsegmente (Sref) durch die entsprechenden Zwischensegmente (1.0) elektrisch in Reihe geschaltet sind, wobei die Länge des neutralen Bereichs eines der beiden durch ein Zwischensegment (1.0) miteinander verbundenen Referenzsegmente (Sref) größer ist als die Länge des neutralen Bereichs des anderen Referenzsegments (Sref).

7. Thermoelektrisches Modul nach einem der Ansprüche 1 bis 6, wobei das thermoelektrische Element (1) eine Prismenform, vorzugsweise mit einer rechteckigen Grundfläche, aufweist.

8. Thermoelektrisches Modul nach einem der Ansprüche 1 bis 6, wobei das thermoelektrische Element (1) eine Form mit einem ringförmigen Querschnitt mit einem spezifischen Innendurchmesser (Di) und einem spezifischen Außendurchmesser (De), der größer als der Innendurchmesser (Di) ist, aufweist und eine Öffnung (3s), die sich vom Innendurchmesser (Di) zum Außendurchmesser (De) erstreckt, aufweist.

9. Thermoelektrisches Modul nach Anspruch 8, wobei das thermoelektrische Element (1) eine Vielzahl von Trennnuten (3.1, 3.2) aufweist, die unterteilt sind in eine erste Art von Trennnut (3.1), die sich vom Innendurchmesser (Di) Richtung Außendurchmesser (De) erstreckt, aber diesen nicht erreicht, und eine zweite Art von Trennnut (3.2), die sich vom Außendurchmesser (De) Richtung Innendurchmesser (Di) erstreckt, aber diesen nicht erreicht, wobei die zwei Arten von Trennnuten (3.1, 3.2) wechselweise entlang des thermoelektrischen Elements (1) um eine Mittelachse (1e) des genannten thermoelektrischen Elements (1) herum angeordnet sind.

10. Thermoelektrisches Modul nach Anspruch 8 oder 9, wobei das thermoelektrische Element (1) eine Scheibe, ein Ring oder ein Zylinder ist.

11. Thermoelektrisches Modul nach einem der Ansprüche 1 bis 10, umfassend einen ersten Anschluss (C1) und einen zweiten Anschluss (C2) zur Verbindung desselben nach außen, wobei jeder der genannten Anschlüsse (C1, C2) vorzugsweise durch Schweißen an einem jeweiligen Referenzsegment (Sref) befestigt ist, wobei die genannten beiden Referenzsegmente (Sref) die in der elektrischen Reihenschaltung am weitesten voneinander entfernt angeordneten Referenzsegmente (Sref) des thermoelektrischen Elements (1) sind.

12. Thermoelektrisches Modul nach Anspruch 11, umfassend eine Basis (5), wobei der erste Anschluss (C1) und der zweite Anschluss (C2) vorzugsweise durch Schweißen an der genannten Basis (5) befestigt sind.

13. Thermoelektrisches Modul nach einem der Ansprüche 1 bis 10, umfassend eine Vielzahl von thermoelektrischen Elementen (1), wobei jeweils zwei thermoelektrische Elemente (1) durch ein entsprechendes Befestigungselement (4), das vorzugsweise durch Schweißen an einem jeweiligen Referenzsegment (Sref) der einzelnen genannten thermoelektrischen Elemente (1) befestigt ist, miteinander verbunden sind.

14. Thermoelektrisches Modul nach Anspruch 13, umfassend eine Basis (5), wobei die Befestigungselemente (4) vorzugsweise durch Schweißen an der genannten Basis (5) befestigt sind.

15. Thermoelektrisches Modul nach Anspruch 13 oder 14, umfassend einen ersten Anschluss (C1) und einen zweiten Anschluss (C2) zur Verbindung desselben nach außen, wobei jeder der genannten Anschlüsse (C1, C2) vorzugsweise durch Schweißen an einem Referenzsegment (Sref) eines jeweiligen thermoelektrischen Elements (1) befestigt ist, wobei die genannten beiden Referenzsegmente (Sref) die in der elektrischen Reihenschaltung am weitesten voneinander entfernt angeordneten Referenzsegmente (Sref) sind.

## Revendications

1. Module thermoélectrique comprenant au moins un élément thermoélectrique (1) à propriétés thermoélectriques, l'élément thermoélectrique (1) comprenant une première face de référence (1.1) et une deuxième face de référence (1.2) disposées l'une en face de l'autre, et au moins une rainure de division (3 ; 3.1, 3.2) divisant ledit élément thermoélectrique (1) en deux segments de référence (Sref) réunis au moyen d'un segment intermédiaire (1.0) et s'étendant de l'une desdites faces de référence (1.1, 1.2) à l'autre face de référence (1.1, 1.2), les deux segments de référence (Sref) comprenant une partie de la première face de référence (1.1) et une partie de la deuxième face de référence (1.2) de l'élément thermoélectrique (1), tous les segments (Sref, 1.0) étant électriquement connectés en série, **caractérisé en ce qu'**au moins un des segments de référence (Sref) comprend une zone neutre en court-circuit d'une longueur donnée entre les parties correspondantes des deux faces de référence (1.1, 1.2), de sorte que ladite zone neutre fait que la chute de tension possible entre les parties correspondantes des deux faces de référence opposées (1.1, 1.2) n'est pas la même dans les deux segments de référence (Sref), ce qui permet d'avoir une différence de tension entre les deux segments de référence (Sref).

2. Module thermoélectrique selon la revendication 1, dans lequel le segment de référence (Sref) comprend une zone s'étendant pour générer une zone d'une longueur donnée entre les parties correspondantes des deux faces de référence (1.1, 1.2) qui est métallisée ou en contact avec un élément conducteur (2), ladite zone étant une zone neutre.

3. Module thermoélectrique selon la revendication 2, dans lequel l'élément conducteur (2) est un revêtement métallique, de préférence un revêtement d'argent, comprenant une conductivité électrique supérieure à la conductivité électrique de l'élément thermoélectrique (1).

4. Module thermoélectrique selon l'une quelconque des revendications 1 à 3, dans lequel l'élément thermoélectrique (1) comprend une pluralité de rainures de division (3 ; 3.1, 3.2), chaque rainure de division (3 ; 3.1, 3.2) divisant l'élément thermoélectrique (1) en deux segments de référence (Sref) communiqués par un segment intermédiaire correspondant (1.0) et tous les segments de référence (Sref) étant électriquement connectés en série les uns aux autres par les segments intermédiaires correspondants (1.0), un des deux segments de référence (Sref) divisé par chacune des rainures de division (3 ; 3.1, 3.2) comprenant une zone neutre, et les zones neutres étant réparties de telle manière dans l'élément thermoélectrique (1) qu'un seul des segments de référence (Sref) reliés entre eux par un segment intermédiaire (1.0) comprend une desdites zones neutres.

5. Module thermoélectrique selon l'une quelconque des revendications 1 à 3, dans lequel les deux segments de référence (Sref) séparés par une rainure de division (3 ; 3.1, 3.2) comprennent au moins une zone neutre, la zone neutre de l'un des segments de référence (Sref) comprenant une longueur plus grande entre les parties correspondantes des faces de référence opposées (1.1, 1.2) que la longueur entre les parties correspondantes desdites faces de référence (1.1, 1.2) de l'autre segment de référence (Sref).

6. Module thermoélectrique selon la revendication 5, dans lequel l'élément thermoélectrique (1) comprend une pluralité de rainures de division (3 ; 3.1, 3.2), chaque rainure de division (3 ; 3.1, 3.2) divisant l'élément thermoélectrique (1) en deux segments de référence (Sref) communiqués par un segment intermédiaire correspondant (1.0) et tous les segments de référence (Sref) étant reliés électriquement en série les uns aux autres par les segments intermédiaires correspondants (1.0), la longueur de la zone neutre de l'un des deux segments de référence (Sref) reliés par un segment intermédiaire (1.0) étant supérieure à la longueur de la zone neutre de l'autre segment de référence (Sref).

7. Module thermoélectrique selon l'une quelconque des revendications 1 à 6, dans lequel l'élément thermoélectrique (1) comprend une forme de prisme, de préférence avec une base rectangulaire.

8. Module thermoélectrique selon l'une quelconque des revendications 1 à 6, dans lequel l'élément thermoélectrique (1) comprend une forme avec une section annulaire avec un diamètre intérieur spécifique (Di) et un diamètre extérieur spécifique (De) supérieur au diamètre intérieur (Di), et comprend une ouverture (3s) s'étendant du diamètre intérieur (Di) au diamètre extérieur (De).

9. Module thermoélectrique selon la revendication 8, dans lequel l'élément thermoélectrique (1) comprend une pluralité de rainures de division (3.1, 3.2) qui sont divisées en un premier type de rainure de division (3.1), s'étendant du diamètre intérieur (Di) vers le diamètre extérieur (De) sans l'atteindre, et un deuxième type de rainure de division (3.2), s'étendant du diamètre extérieur (De) vers le diamètre intérieur (Di) sans l'atteindre, les deux types de rainures de division (3.1, 3.2) étant répartis de manière alternée le long de l'élément thermoélectrique (1), autour d'un axe central (1e) dudit élément thermoélectrique (1).

10. Module thermoélectrique selon la revendication 8 ou 9, dans lequel l'élément thermoélectrique (1) est un disque, un anneau ou un cylindre.

11. Module thermoélectrique selon l'une quelconque des revendications 1 à 10, comprenant un premier connecteur (C1) et un deuxième connecteur (C2) pour sa connexion à l'extérieur, chacun desdits connecteurs (C1, C2) étant fixé à un segment de référence respectif (Sref), de préférence au moyen d'une soudure, lesdits deux segments de référence (Sref) étant les segments de référence (Sref) de l'élément thermoélectrique (1) disposés le plus loin l'un de l'autre dans la connexion électrique en série.

12. Module thermoélectrique selon la revendication 11, comprenant une base (5), le premier connecteur (C1) et le deuxième connecteur (C2) étant fixés à ladite base (5), de préférence au moyen d'une soudure.

13. Module thermoélectrique selon l'une quelconque des revendications 1 à 10, comprenant une pluralité d'éléments thermoélectriques (1), chaque deux éléments thermoélectriques (1) étant reliés entre eux au moyen d'un élément de fixation correspondant (4) qui est fixé à un segment de référence respectif (Sref) de chacun desdits éléments thermoélectriques (1), de préférence au moyen d'une soudure.

14. Module thermoélectrique selon la revendication 13, comprenant une base (5), les éléments de fixation (4) étant fixés à ladite base (5), de préférence au moyen d'une soudure.

15. Module thermoélectrique selon la revendication 13 ou 14, comprenant un premier connecteur (C1) et un deuxième connecteur (C2) pour sa connexion à l'extérieur, chacun desdits connecteurs (C1, C2) étant fixés à un segment de référence (Sref) d'un élément thermoélectrique respectif (1), de préférence au moyen d'une soudure, lesdits deux segments de référence (Sref) étant les segments de référence (Sref) disposés le plus loin l'un de l'autre dans la connexion électrique en série.
